# EUROPÄISCHE PATENTSCHRIFT

(11) **EP 1 399 262 B1**
(45) Veröffentlichungstag und Bekanntmachung des Hinweises auf die Patenterteilung: **13.10.2004**
(21) Anmeldenummer: 02754726.4
(22) Anmeldetag: 20.06.2002
(51) Int. Cl.: B01L 3/02, B01L 3/00

(54) **PIPETTENVORRICHTUNG UND VERFAHREN ZU DEREN HERSTELLUNG**
PIPETTING DEVICE AND METHOD FOR PRODUCING THE SAME
DISPOSITIF DE PIPETTAGE ET SON PROCEDE DE FABRICATION

(30) Priorität: 22.06.2001 DE 10130218
(43) Veröffentlichungstag der Anmeldung: 24.03.2004
(73) Patentinhaber: Infineon Technologies AG, 81669 München (DE)
(72) Erfinder: FRITZ, Michaela, 81673 München (DE); DERTINGER, Stephan, 80335 München (DE); FUCHS, Karin, 81739 München (DE); HANEDER, Thomas, 85221 Dachau (DE); HANKE, Hans-Christian, 81479 München (DE); JENKNER, Martin, 82152 Planegg (DE); LEHMANN, Volker, 80689 München (DE); PAULUS, Christian, 81247 München (DE)
(74) Vertreter: Müller-Boré & Partner Patentanwälte
(86) Internationale Anmeldenummer: PCT/EP2002/006855
(87) Internationale Veröffentlichungsnummer: WO 2003/000421

(56) Entgegenhaltungen:
- WO-A-01/32310
- DE-A- 19 936 302
- PATENT ABSTRACTS OF JAPAN vol. 1997, no. 02, 28. Februar 1997 (1997-02-28) & JP 08 252465 A (HITACHI KOKI CO LTD), 1. Oktober 1996 (1996-10-01)

## Beschreibung

Die Erfindung betrifft eine Vorrichtung, insbesondere für ein Patch-Clamping von Vesikeln und/oder für ein Dispensieren von kleinen, definierten Flüssigkeitsmengen auf Oberflächen sowie ein Verfahren zum Ausbilden zumindest einer Pipette in einem Substrat.

Insbesondere im Bereich der modernen Biotechnologie ist die Manipulation kleinster Flüssigkeitsmengen im Pico- bis Nanoliterbereich von zentraler Bedeutung. Beispielsweise ist das parallele Dispensieren von definierten Flüssigkeitsmengen in diesem Volumenbereich ein grundlegender Schritt bei der Herstellung von sogenannten Biochips. In Analogie zu den anhaltenden Bestrebungen in der Halbleitertechnologie, die Strukturgrößen von elektronischen Halbleiterbauelementen zu reduzieren, wird gleichsam versucht, die Informationsdichte (Spotdichte) auf Biochips zu erhöhen. Hierduch läßt sich der Durchsatz von mit den Biochips ausführbaren Assays steigern, womit insbesondere eine Kostenreduktion verbunden ist. Um hochdichte Arrays kostengünstig und schnell in großen Mengen herstellen zu können, werden sogenannte Druckköpfe benötigt, die parallel eine große Zahl (insbesondere ≥ 96 Spots) pro 'Druckschritt' drucken können. Somit müssen derartige Druckköpfe dafür ausgelegt sein, parallel eine große Zahl wohldefinierter, kleinster Flüssigkeitsmengen mit großer Positionsgenauigkeit an vorbestimmte Spotpositionen reproduzierbar auf eine Oberfläche aufbringen zu können. Die Spotabstände liegen dabei typischerweise in Bereichen zwischen 10µm und 1000µm. Neben hohen Spotdichten und kleinsten, aber genau definierten Dispensiermengen ist eine hohe Uniformität und Reproduzierbarkeit des Druckprozesses über das Substrat erforderlich. Die im Stand der Technik bekannten Druckköpfe erfüllen dieses Anforderungsprofil nur bedingt.

Die Erfindung ist ferner mit Vorteil bei der von Neher und Sackmann erfundenen Patch-Clamp-Technik einsetzbar, welche seit vielen Jahren zu den zentralen Labormethoden in vielen Bereichen der Zellbiologie gehört. Mit der Patch-Clamp-Technik wird ein relativ großer und gleichzeitig gut abgedichteter Zugang zu einem Vesikel bzw. zu einer Zelle geschaffen, der es einerseits erlaubt, die Zusammensetzung des Cytoplasmas zu manipulieren, und andererseits einen niederohmigen elektrischen Zugang mit sehr geringer Leckleitfähigkeit darstellt. Bei einem Patch-Clamp wird eine extrem dichte Verbindung der ringförmigen Spitze einer Glasmikropipette mit einer Zellmembran erreicht. Charakterisiert wird die Abdichtung durch den elektrischen Widerstand des ringförmigen Kontakts. Dieser Widerstand liegt vorzugsweise im Gigaohm-Bereich, d.h. es liegt ein sogenannter "Giga Seal" vor.

Die zum Patch-Clamping verwendeten Patchpipetten werden unter mechanischem Zug und Hitze aus einem Glasröhrchen hergestellt. Dieser Prozeß ist relativ aufwendig und schwer zu kontrollieren. Ferner ist die Handhabung solcher einzelner Patchpipetten sehr aufwendig, da eine Positionier- und Haltegenauigkeit im Sub-µm-Bereich erreicht werden muß. Dazu sind sehr aufwendig gestaltete Mikromanipulatoren erforderlich, welche eine große Steifigkeit aufweisen und äußerst vibrationsarm konstruiert und gelagert werden müssen. Solche Anlagen sind zum einen sehr teuer und ferner auch sehr groß, so daß nicht mehr als drei bis vier Pipetten gleichzeitig eingesetzt werden können.

Ein weiteres Problem stellt die Streukapazität der Pipette dar, deren Wand im Bereich der Spitze ungefähr eine Stärke von 200 nm bis 300 nm aufweist. Um die Streukapazität bzw. parasitäre Kapazität der Pipettenwand so gering wie möglich auszubilden, wird daher häufig die Wanddicke einer Patchpipette durch manuelles Auftragen von Silikon bis fast an die Spitze erhöht.

Es ist daher Aufgabe der Erfindung, eine Vorrichtung insbesondere für ein Patch-Clamping von Vesikeln mit einem äußerst niederohmigen Zugang zu dem Vesikel oder für ein Dispensieren von kleinen, definierten Flüssigkeitsmengen auf Oberflächen sowie ein Verfahren zur Herstellung einer derartigen Vorrichtung zu schaffen.

Diese Aufgabe wird durch eine Vorrichtung mit den im Anspruch 1 angegebenen Merkmalen sowie durch ein Verfahren mit den im Anspruch 10 angegebenen Merkmalen gelöst. Bevorzugte Ausführungsformen ergeben sich aus den entsprechenden Unteransprüchen.

Die erfindungsgemäße Vorrichtung eignet sich insbesondere für ein Patch-Clamping von Vesikeln. Unter Vesikeln werden hier Objekte, insbesondere biologische Objekte aus einer geschlossenen Lipidmembran verstanden, welche in flüssiger Phase, vorzugsweise Wasser, handhabbar sind. Allgemein sind dies Partikel, welche eine Lipidmembran mit zumindest einer Lipidschicht umfassen. Beispiele für solche Vesikel sind Zellen, insbesondere Nervenzellen, gentechnisch manipulierte Zellen mit spannungsabhängigen Ionenkanälen, aus Erythrozyten fusionierte Riesenzellen oder Kugeln aus Lipiddoppelschichten.

Ferner eignet sich die erfindungsgemäße Vorrichtung zum wohldefinierten, reproduzierbaren Aufbringen ('Drucken') kleinster Flüssigkeitsmengen im Pico- bis Nanoliterbereich auf eine Oberfläche. Ein derartiger 'Druckvorgang' ist insbesondere bei der Herstellung von Biochips ein zentraler Vorgang.

Bei der erfindungsgemäßen Vorrichtung ist in einem Substrat zumindest eine Pipette in Form eines Durchgangsloches mit einem vorbestimmten Durchmesser ausgebildet, wobei ein Rand des Durchgangsloches um ein vorbestimmtes Maß von einer benachbarten Oberfläche des Substrats vorsteht. Dieser vorstehende Rand bildet eine Pipettenspitze ähnlich der Spitze einer herkömmlichen Patchpipette. Mit einer derart ausgestalteten Pipettenspitze kann ein "Giga-Seal", d.h. ein dichter, niederohmiger Zugang zu einem Vesikel bzw. einer Zelle geschaffen werden, dessen Abdichtwiderstand, d.h. der Widerstand nach außen, im Gigaohmbereich liegt.

Die Pipette mit dem vorstehenden Rand kann ferner auch in Form einer insbesondere gespaltenen Drucknadel bzw. -düse bzw. -kapillare ausgebildet sein, so daß sich die erfindungsgemäße Vorrichtung als 'Druckkopf' eignet. Der Rand kann gemäß der gewünschten geometrischen Form der Pipettenspitze ausgebildet werden, so daß an bzw. mit ihm insbesondere optimales Patch-Clamping bzw. optimale Flüssigkeitstransfereigenschaften erreicht werden können. Der Durchmesser des Durchgangsloches liegt im Bereich des Randes, welcher die Pipettenspitze bildet, vorzugsweise im Bereich von 0,5 bis 20 µm, weiter bevorzugt 1 bis 2µm.

Die Anordnung einer solchen Pipette in einem Substrat bzw. Träger ermöglicht eine hohe mechanische Stabilität, so daß auf aufwendige Mikromanipulatoren verzichtet werden kann. Das Substrat ist vorzugsweise planar bzw. flächig ausgebildet. Für ein Patch-Clamping werden die einzelnen Vesikel bzw. Zellen auf dieses im Bereich der Pipettenspitze bzw. des Randes aufgesetzt. Dazu können zusätzlich an der Substratoberfläche Positionierhilfen für Vesikel angeordnet sein, so daß ein Vesikel genau ausgerichtet auf der Pipettenspitze plaziert werden kann. In dem Substrat kann das Durchgangsloch, d.h. die Pipette an einer genau definierten Position ausgebildet werden, so daß später eine sehr leichte und automatische Anordnung eines Vesikels möglich ist.

Bei einem Einsatz der erfindungsgemäßen Vorrichtung als Druckkopf kann das Abschnür- bzw. Abrißverhalten der von der Pipette zu dispensierenden Flüssigkeitstropfen über die spezielle Geometrie der überstehenden Ränder gesteuert werden. Die Form dieser Ränder ist in weiten Bereichen frei wählbar. Insbesondere sind sich verjüngende, gerade oder trichterförmige Randgeometrien möglich. Über derartige Randgeometrien sowie die weiteren geometrischen Eigenschaften der Pipette an ihrem Rand- bzw. Öffnungsbereich, insbesondere der Randdicke, Randhöhe und lokalen Randkrümmung, kann eine exakte Abstimmung der Pipettenform auf das angestrebte Abschnür- bzw. Abrißverhalten erzielt werden. In einer senkrecht zur Pipettenlängsachse verlaufenden Schnittfläche kann die Öffnungsgeometrie der Pipette insbesondere rund, rechteckig oder schlitzförmig gestaltet sein. Ebenso kann der Neigungswinkel (Öffnungswinkel) der überstehenden Wände bzw. Ränder in einem weiten Bereich variiert werden. Hierdurch wird eine hohe Uniformität des Druck- bzw. Dispensierprozesses mit einer erfindungsgemäßen Vorrichtung über das zu bedruckende Substrat erreicht, wobei sich reproduzierbar kleinste Dispensiermengen im Pico- bis Nanoliterbereich einstellen lassen.

Vorzugsweise umfaßt zumindest der Rand zumindest ein anderes Material als das Substrat und vorzugsweise SiO₂ oder Si₃N₄. Ferner kann der Rand auch Ta₂O₅, HfO₂, Y₂O₃, Al₂O₃, Nb₂O₅, TiO₂, TaO₂ und/oder Nitrid oder Oxynitrid von Al, Si oder Hf aufweisen.

Für einen Einsatz der erfindungsgemäßen Vorrichtung als Patch-Clamp von Vesikeln kann der Rand vorzugsweise aus einem Material ausgebildet sein, welches im wesentlichen demjenigen einer herkömmlichen Patchpipette aus Glas ähnlich ist, um ähnlich gute Dichteigenschaften zu einer Vesikelmembran zu gewährleisten. Dabei kann das Material des Randes, d.h. der Pipettenspitze, welche mit einem Vesikel in Kontakt tritt, im wesentlichen unabhängig von dem Material des Substrats gewählt werden. Das Material des Substrats kann nach mechanischen Gesichtspunkten ausgewählt werden, um eine möglichst große Stabilität bzw. Steifigkeit der Vorrichtung zu erreichen. Die Dicke des Randes liegt bevorzugt im Bereich von 200 bis 300 nm und entspricht somit insbesondere der Wanddicke herkömmlicher Patch-Pipetten..

Weiter bevorzugt besteht eine Innenwandung des Durchgangsloches zumindest teilweise aus einem anderen Material als das Substrat und vorzugsweise aus SiO₂ oder Si₃N₄. Ferner kann die Innenwandung auch Ta₂O₅, HfO₂, Y₂O₃, Al₂O₃, Nb₂O₅, TiO₂, TaO₂ und/oder Nitrid oder Oxynitrid von Al, Si oder Hf aufweisen. Insbesondere kann in einem solchen Fall die Innenwandung des Durchgangsloches einstückig aus demselben Material wie der Rand ausgebildet werden. Eine solche Ausgestaltung bildet im wesentlichen eine in ein Substrat integrierte Pipette, welche eine Innenfläche mit gewünschten Materialeigenschaften aufweist. Die Beschichtung bzw. das Material der Innenwandung des Durchgangsloches kann insbesondere gemäß elektrischer Anforderungen ausgewählt werden, um eine möglichst geringe Streukapazität der Pipette bei einem Patch-Clamp zu gewährleisten. Die Dicke der Beschichtung kann beliebig eingestellt werden, liegt jedoch vorzugsweise im Bereich von 200 bis 300 nm.

Die Innenseite des Randes und vorzugsweise die Innenseite des Durchgangsloches kann vorzugsweise aus einem anderen Material als die Außenseite des Randes bestehen. Bei einer solchen Anordnung ist der Rand somit zumindest zweischichtig ausgebildet, so daß die Eigenschaften der Pipettenaußenseite unabhängig von den Eigenschaften der Pipetteninnenwandung eingestellt werden können. Da vorzugsweise die Innenwandung des Durchgangsloches aus demselben Material wie der Rand, d.h. einstückig mit diesem ausgebildet wird, kann vorzugsweise auch die Innenwandung des Durchgangsloches entsprechend zumindest aus zwei unterschiedlichen Materialschichten ausgebildet sein. Dabei ist die erste Materialschicht dem Substrat zugewandt, und die zweite Materialschicht bildet die eigentliche Pipetteninnenwand.

Bevorzugt ist an dem Rand und/oder an der Innenwandung des Durchgangsloches zumindest eine Schicht aus einem elektrisch leitfähigem Material ausgebildet. Vorzugsweise sind dabei der Rand und die Beschichtung an der Innenwandung der Durchgangsbohrung dreischichtig aufgebaut. Dabei haben zum Beispiel die beiden äußeren, das heißt die dem Loch zugewande und die dem Substrat zugewandte Schicht elektrisch isolierende Eigenschaften, während die mittlere Schicht von elektrisch leitfähiger Natur ist. Diese mittlere Schicht kann zum Beispiel aus einem Metall wie Aluminium oder ITO (Indium-Zinnoxid) aufgedampft werden. Damit kann eine vom Substrat unabhängige weitere elektrische Abschirmung des Pipettenlochs erreicht werden, die das Übersprech- und Abschirmverhalten der jeweiligen Pipette zum Beispiel nach Art eines "driven shield" verbessert, was für einen Einsatz der Vorrichtung bei einem Patch-Clamping von Vorteil ist.

Vorzugsweise ist ein distales Ende des Randes gerundet ausgebildet. Das distale Ende ist das äußere Ende des Randes, welches die Pipettenspitze bildet. Die Rundung kann ähnlich zu einer herkömmlichen Glaspipette ausgebildet werden. Es ist jedoch auch möglich, die Form des Randes, d.h. der Pipettenspitze frei zu definieren, um insbesondere eine optimale Verbindung zu einer Vesikel- bzw. Zellmembran zu gewährleisten bzw. ein optimales Flüssigkeitstransferverhalten des Druckkopfes zu erzielen.

Weiter bevorzugt verengt sich das Durchgangsloch zu einem distalen Ende des Randes hin. Somit wird eine Pipettenform geschaffen, welche im wesentlichen der Form einer herkömmlichen Patchpipette entspricht und sich daher besonders für ein Patch-Clamping von Vesikeln eignet. Im Bereich der Pipettenspitze, d.h. an dem distalen Ende des Randes, weist das Durchgangsloch vorzugsweise einen Durchmesser von 0,5 bis 20 µm, vorzugsweise 1 bis 2 µm auf. Gleichermaßen kann eine Pipettenform von Vorteil sein, bei welcher sich das Durchgangsloch zu einem distalen Ende des Randes hin aufweitet bzw. öffnet.

Das Substrat besteht vorzugsweise aus einem Material, welches Silizium umfaßt. In Silizium lassen sich leicht auf photolithographischem Weg an vorbestimmten Stellen sehr dünne Löcher ausbilden. Ein solches Verfahren zum Ausbilden von Löchern mit geringem Durchmesser in Silizium ist aus der WO 99/58746 bekannt. Anstelle von Silizium können jedoch auch andere Materialien, insbesondere Halbleitermaterialien sowie deren dotierte Modifikationen, wie beispielsweise Germanium oder GaAs, verwendet werden. Insbesondere sollten sich diese Materialien zur Bearbeitung mit dem in WO 99/58746 genannten Verfahren eignen, d.h. photolithographisch strukturierbar und mit anisotropen Ätzverfahren bearbeitbar sein. Auf die WO 99/58746 wird hinsichtlich des dort beschriebenen Herstellungsverfahrens in vollem Umfang bezug genommen, so daß WO 99/58746 insoweit als Teil der Gesamtoffenbarung der vorliegenden Anmeldung zu verstehen ist.

Bevorzugt sind in dem Substrat mehrere Pipetten ausgebildet, welche vorzugsweise raster- bzw. matrixartig in dem Substrat angeordnet sind. In einer solchen Anordnung kann eine große Anzahl von einzelnen Pipetten in einem gemeinsamen Träger bzw. Substrat angeordnet werden. Für die Anwendung der erfindungsgemäßen Vorrichtung für ein Patch-Clamping werden vorzugsweise weniger als 400 Pipetten pro mm² verwendet. Für die Anwendung als Druckkopf werden vorzugsweise mehr als 4 und weninger als 2500 Pipetten pro mm² vorgesehen. Das Substrat ist dabei vorzugsweise als planarer Träger, beispielsweise in Form eines Siliziumwafers bzw. -chips, ausgebildet. Durch die gemeinsame Anordnung einer großen Anzahl von Pipetten in einem gemeinsamen Träger kann eine sehr einfach ausgebildete Anordnung der Pipetten mit großer Stabilität bzw. Steifigkeit erreicht werden. Es können somit wesentlich mehr Pipetten gleichzeitig eingesetzt werden, als es insbesondere mit herkömmlichen Glaspipetten möglich war.

Die Abstände benachbarter Pipetten lassen sich durch die photolithographische Definition reproduzierbar in einem Bereich zwischen 5 µm und 500 µm, vorzugseise 10 µm bis 200 µm einstellen.

Für den Einsatz der Vorrichtung für ein Patch-Clamping müssen ferner keine aufwendig gelagerten bzw. gedämpften Manipulationseinrichtungen für die Pipetten verwendet werden. Da die Pipetten an genau definierten Positionen in dem Substrat ausgebildet werden können, können Vesikel bzw. Zellen sehr leicht an diesen vorbestimmten Positionen auf den Pipettenspitzen angeordnet werden. Dazu können zusätzlich Positionierhilfen an dem Substrat ausgebildet sein oder auf dieses aufgesetzt werden. Mit einer so ausgestalteten Vorrichtung kann sehr einfach ein Patch-Clamping einer großen Anzahl von Vesikeln gleichzeitig durchgeführt werden.

Das erfindungsgemäße Verfahren zum Ausbilden zumindest einer Pipette in einem Substrat weist zumindest die nachfolgende Schritte auf. Zunächst wird in dem Substrat ein Loch ausgebildet. Anschließend wird eine veränderte Oberflächenschicht auf zumindest den Innenflächen des Loches ausgebildet. Danach erfolgt ein selektives Abtragen des Substrats, wobei die veränderte Oberflächenschicht im wesentlichen nicht angegriffen wird, so daß diese über die Oberfläche des Substrats vorsteht und einen vorstehenden Rand ausbildet. In einem geeigneten Verfahrensschritt wird das Loch im Laufe des Verfahrens als Durchgangsloch ausgebildet. Auf diese Weise wird in dem Substrat eine integrierte Pipette geschaffen, wobei der vorstehende Rand die Pipettenspitze bildet. Durch dieses Verfahren können in einer vorzugsweise planaren Oberfläche eines Substrats an genau definierten Positionen einzelne Pipetten von vorgegebenem Lochdurchmesser geschaffen werden. Dabei kann eine Vielzahl von Pipetten auf diese Weise gleichzeitig in dem Substrat ausgebildet werden.

Es kann sehr leicht eine Vorrichtung hergestellt werden, welche eine Vielzahl von Pipetten insbesondere zum Patch-Clamping einer Vielzahl von Vesikeln bzw. Zellen oder zum gleichzeitigen reprozierbaren Dispensieren kleinster, genau definierter Flüssigkeitsmengen aufweist. Das erfindungsgemäße Verfahren erlaubt, die Geometrie der Löcher sowie insbesondere der vorstehenden Ränder sehr genau einzustellen. So kann eine genau definierte Dicke des Randes erzeugt werden, indem die Dicke der veränderten Oberflächenschicht entsprechend eingestellt wird. Die Dicke der veränderten Oberflächenschicht und damit des Randes kann insbesondere entsprechend der Wandstärke der Spitzen herkömmlicher Patch-Pipetten auf etwa 200 bis 300 nm eingestellt werden. Durch die Stärke des selektiven Abtragens des Substrats kann ferner die Höhe, um welche der Rand gegenüber der angrenzenden Oberfläche des Substrats vorsteht, genau eingestellt werden. Auch der Durchmesser und die Form des Loches kann an gewünschte Einsatzzwecke angepaßt werden. Vorzugsweise beträgt der Durchmesser des Loches zumindest im Bereich des vorstehenden Randes 0,5 bis 20 µm, weiter bevorzugt 1 bis 2 µm und kann somit insbesondere ähnlich der Spitzen herkömmlicher Patchpipetten aus Glas gewählt werden.

Vorzugsweise ist das Loch zu der Seite hin, an welcher der Rand ausgebildet wird, in sich verjüngender Weise ausgebildet. Das heißt, das Loch weist im wesentlichen die Form einer herkömmlichen Patchpipette auf, wobei der Rand die Pipettenspitze bildet. Auf diese Weise kann die in dem Substrat ausgebildete Pipette im wesentlichen dieselben Eigenschaften aufweisen wie eine herkömmliche Patchpipette, d.h. einen äußerst dichten und niederohmigen Zugang zu einem Vesikel ermöglichen. Dabei werden jedoch aufgrund der Anordnung der Pipette in dem Substrat die oben genannten Vorteile erreicht. Gleichermaßen kann der Rand auch derart geformt werden, daß er sich in Richtung der Pipettenöffnung insbesondere trichterförmig aufweitet.

Das Loch wird vorzugsweise zunächst als Sackloch ausgebildet. Die Ausbildung als Sackloch läßt eine sehr genaue Definition der Form des Loches bzw. der Pipettenspitze zu. Die Bodenform des Sackloches definiert somit später die Form der Pipettenspitze. Da die Form des Sackloches sehr leicht variiert werden kann, kann auf diese Weise auch die Geometrie der Pipettenspitze sehr einfach variiert werden.

In einem weiteren bevorzugten Verfahrensschritt wird nach dem Ausbilden des Sackloches die einer Öffnung des Sackloches entgegengesetzte Seite bis zum Boden des Sackloches abgetragen, so daß das Sackloch geöffnet wird, um ein Durchgangsloch zu bilden. Dabei bildet die Öffnung, welche am Boden des Sackloches durch.Abtragen des Substrats geschaffen wird, später die in der Pipettenspitze.ausgebildete Öffnung. Da die Geometrie des Sackloches und die Stärke des Abtragens des Substrats in weiten Grenzen variiert werden kann, kann durch diese Verfahrensschritte eine vielfältige Variation der Form der Pipettenspitze erreicht werden. Da das Verfahren bzw. der Prozeß sehr sicher gesteuert bzw. geregelt werden kann, ist ferner eine hohe Prozeßsicherheit gegeben, welche eine gute Reproduzierbarkeit der vorgegebenen Form der Pipettenspitze, d.h. des Sackloches und des Substratabtrags gewährleistet.

Vorzugsweise wird das Sackloch zu seinem Boden hin verjüngend ausgebildet. Auf diese Weise erhält das Sackloch im wesentlichen die Form der Spitze einer herkömmlichen Patchpipette. An der Spitze der Pipette, d.h. am Boden des Sackloches, kann später eine ausreichend kleine Öffnung mit einem Durchmesser von vorzugsweise 1 bis 2 µm geschaffen werden. Die so erzeugte Pipette verjüngt sich zu ihrer Öffnung hin.

Weiter bevorzugt wird das Sackloch durch Ätzen ausgebildet. Dabei kann die Position des Sackloches durch ein photolithographisches Verfahren festgelegt werden. Auf diese Weise kann auch sehr leicht gleichzeitig eine große Anzahl von Sacklöchern in dem Substrat ausgebildet werden.

Das Abtragen der der Öffnung des Sackloches entgegengesetzten Seite des Substrats erfolgt vorzugsweise durch chemisches und/oder mechanisches Abtragen. Bei diesem Verfahren kann es sich um ein chemisch-mechanisches Polieren (CMP (chemical mechanical polishing)) handeln. Ein solches Verfahren ermöglicht, das Substrat in einer definierten Dicke abzutragen, um eine Pipettenspitze mit genau definierter Form und vorgegebenem Öffnungsdurchmesser zu schaffen.

weiter bevorzugt werden nach dem selektiven Abtragen die Kanten des vorstehenden Randes gerundet. Dies kann beispielsweise durch Ätzen erfolgen. Auf diese Weise wird eine Form des Randes, d.h. der Pipettenspitze geschaffen, welche derjenigen herkömmlicher Patchpipetten entspricht. Es können somit insbesondere ähnliche Eigenschaften wie bei einer herkömmlichen Patchpipette sichergestellt werden, insbesondere die Eignung für einen "Giga-Seal" mit einer Vesikelmembran.

Die veränderte Oberflächenschicht kann zusätzlich auf einer Oberfläche des Substrats ausgebildet werden. Auf diese Weise kann sichergestellt werden, daß bei dem selektiven Abtragen nur diejenige Oberfläche des Substrats abgetragen wird, an der der vorstehende Rand, d.h. die Pipettenspitze ausgebildet werden soll. Die entgegengesetzte Seite des Substrats wird während des selektiven Abtragens durch die veränderte Oberflächenschicht geschützt und somit nicht abgetragen.

Die veränderte Oberflächenschicht kann alternativ auf der gesamten Oberfläche des Substrats ausgebildet werden und auf der Seite des Substrats, an welcher der Rand ausgebildet wird, vor dem selektiven Abtragen vorzugsweise chemisch und/oder mechanisch abgetragen werden. Dieser Abtragvorgang kann gleichzeitig mit dem Abtragen des Substrats zum Öffnen des Sackloches erfolgen. Auf diese Weise kann das Herstellungsverfahren vereinfacht werden, da die veränderte Oberflächenschicht zunächst auf der gesamten Oberfläche des Substrats ausgebildet wird und anschließend auf der Seite; auf der ein selektiver Abtrag erfolgen soll, vorzugsweise gemeinsam mit einem Teil des darunterliegenden Substrats wieder abgetragen wird. Dieser Schritt bildet vorteilhafterweise keinen zusätzlichen Verfahrensschritt, da das Substrat sowieso zum Öffnen des Sackloches abgetragen werden muß.

Das selektive Abtragen des Substrats erfolgt vorzugsweise durch Ätzen, wobei ein Ätzmittel verwendet wird, welches die veränderte Oberflächenschicht im wesentlichen nicht angreift. Das heißt, die veränderte Oberflächenschicht besteht aus einem anderen Material als das Substrat. Das Ätzmittel trägt dann nur das Substrat, jedoch nicht die veränderte Oberflächenschicht ab. Somit bleibt nach dem Abtrag des Substrats die veränderte Oberflächenschicht, welche an der Innenseite des Loches ausgebildet ist, stehen und steht gegenüber der Oberfläche des Substrats an der Seite, an welcher der Substratabtrag erfolgte, vor. Die veränderte Oberflächenschicht bildet dann einen vorstehenden Rand, welcher als Pipettenspitze dient. Durch die Dauer des Ätzprozesses kann die Tiefe des Substratabtrags sehr genau eingestellt werden, so daß die Höhe des vorstehenden Randes ebenfalls genau definiert werden kann.

Vorzugsweise besteht das Substrat aus einem Material, welches ein Halbleitermaterial und insbesondere Silizium umfaßt. In einem Halbleitermaterial und insbesondere in Silizium können sehr leicht die erforderlichen kleinen Löcher ausgebildet werden. Ein Verfahren zur Ausbildung solcher Löcher mit kleinem Durchmesser in Silizium ist aus der WO 99/58746 bekannt. Ferner ermöglicht ein Halbleitermaterial und insbesondere Silizium, daß an dem Substrat selber elektrisch aktive Strukturen ausgebildet werden können. Solche Strukturen werden vorzugsweise an der dem Rand bzw. der Pipettenspitze entgegengesetzten Oberfläche des Substrats ausgebildet. Ferner kann das Substratmaterial bei passender Beschaltung auch als Heizelement zur kontrollierten Desorption störender Verunreinigungen auf dem Rand bzw. den Rändern der Pipettenspitzen verwendet werden.

Weiter bevorzugt wird zumindest die veränderte Oberflächenschicht durch Beschichten und/oder Modifizieren der Oberfläche des Substrats, insbesondere Oxidieren oder Nitrieren, erzeugt. Die Oberflächenschicht kann in Form einer Beschichtung auf das Substratmaterial aufgebracht werden. Dabei wird vorzugsweise ein Beschichtungsmaterial verwendet, welches eine ähnliche Zusammensetzung aufweist wie das Glas bzw. Quarzglas, aus dem üblicherweise Patchpipetten gefertigt werden. Anstatt die Oberfläche zu beschichten, kann auch eine obere Schicht bzw. eine Oberflächenschicht des Substrats modifiziert bzw. chemisch verändert werden. Dies kann durch Reaktion mit verschiedenen Substanzen erfolgen. Beispielsweise kann ein Oxidieren oder Nitrieren in einer Sauerstoff- bzw. Stickstoffatmosphäre erfolgen. Im Falle von Silizium als Substratmaterial kann durch Oxidieren oder Nitrieren sehr leicht eine veränderte Oberflächenschicht aus SiO₂ bzw. Si₃N₄ geschaffen werden.

Die veränderte Oberflächenschicht kann zumindest im Bereich des Loches zumindest abschnittweise mehrere Schichten aus vorzugsweise verschiedenen Materialien aufweisen. Dazu können beispielsweise zwei Schichten aus unterschiedlichen Materialien nacheinander auf das Substrat aufgebracht werden. Alternativ ist es denkbar, die erste Schicht durch Modifizieren einer Oberflächenschicht des Substrats, beispielsweise durch Oxidieren oder Nitrieren zu schaffen und anschließend eine zweite Schicht durch Beschichten aufzubringen. Es ist umgekehrt auch denkbar, zunächst eine Schicht durch Beschichten aufzubringen und anschließend eine Oberflächenschicht der aufgebrachten Materialschicht zu modifizieren, beispielsweise durch Oxidieren oder Nitrieren. Eine zweischichtige Ausbildung der veränderten Oberflächenschicht bewirkt, daß nach dem selektiven Abtragen des Substrats der vorstehende Rand zweischichtig ausgebildet ist und insbesondere eine Außenseite aufweist, welche aus einem anderen Material besteht als die Innenseite. So kann der Rand bzw. die Pipettenspitze optimal an einen gewünschten Einsatzzweck angepaßt werden. Die Schicht, welche die Innenwandung des Randes bildet, erstreckt sich vorzugsweise weiter durch das Loch und bildet die Innenwandung des Loches, so daß die in dem Substrat gebildete Pipette an ihrer Innenseite eine homogene durchgehende Materialschicht aufweist. Dieses Material wird insbesondere so gewählt, daß eine Streukapazität der Pipette möglichst gering ausgebildet werden kann. Zusätzlich ist es möglich eine elektrisch leitfähige Schicht beispielsweise durch Aufdampfen eines Metalles wie Aluminium oder ITO (Indium-Zinnoxid) auszubilden. Wird eine solche leitfähige Schicht vorgesehen, ist ein dreischichtiger Aufbau der veränderten Oberflächenschicht bevorzugt, bei dem die elektrisch leitfähige Schicht zwischen zwei elektrisch isolierenden Schichten ausgebildet wird.

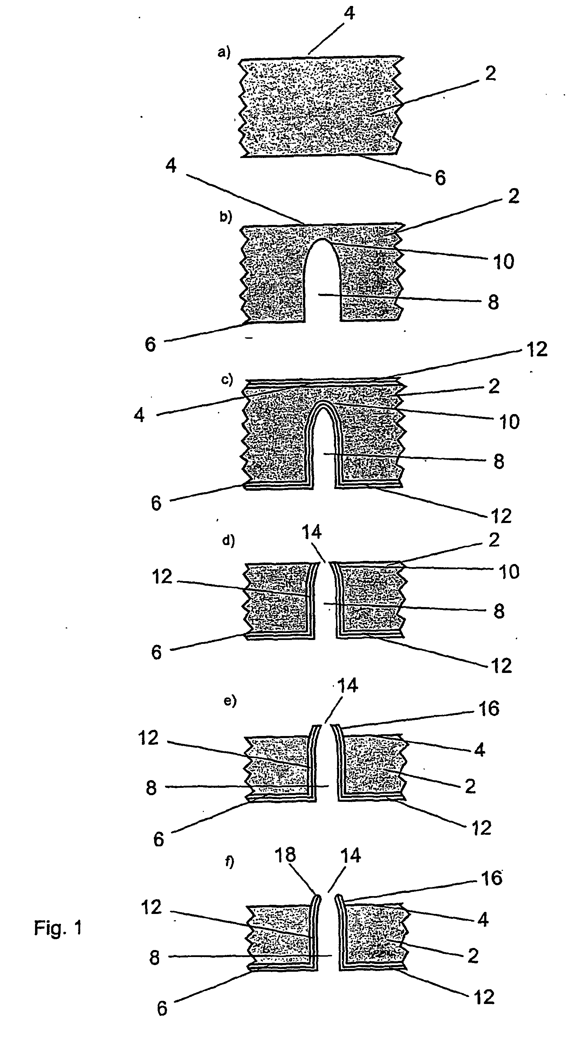

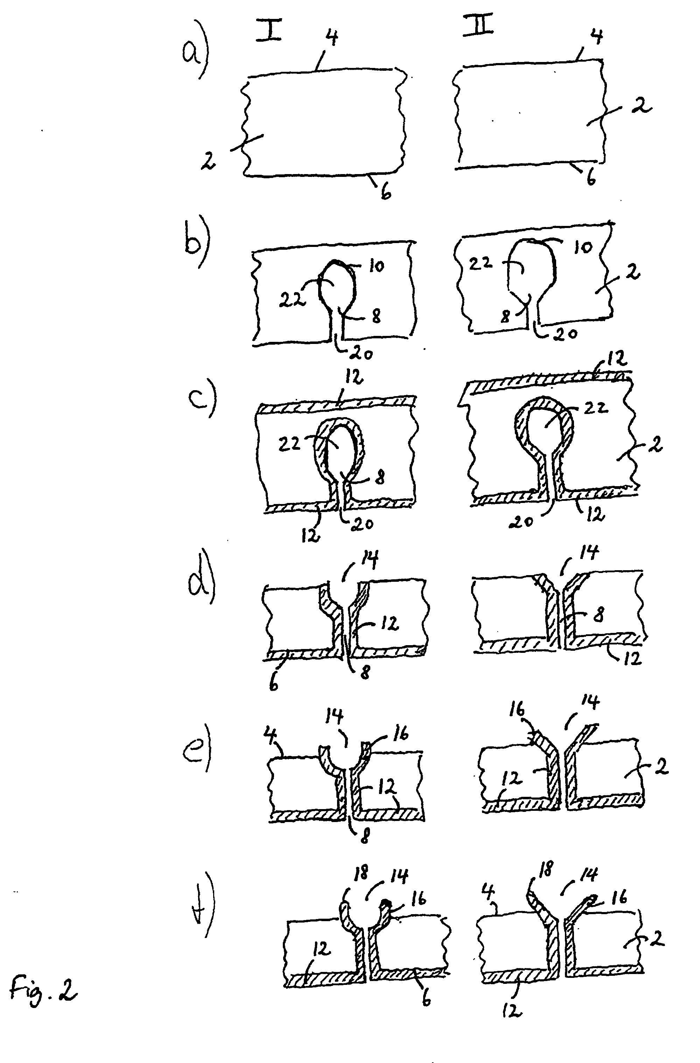

Nachfolgend wird die Erfindung beispielhaft anhand der beigefügten Figuren beschrieben. Die Fig. 1 zeigt schematisch den Ablauf einer bevorzugten Variante des erfindungsgemäßen Verfahrens zur Herstellung einer bevorzugten Ausführungsform der erfindungsgemäßen Vorrichtung. Fig. 2 zeigt den Prozeßablauf einer weiteren Variante des erfindungsgemäßen Verfahrens.

Fig. 1a zeigt schematisch im Schnitt einen Teil eines Trägers bzw. eines Substrats 2. Das Substrat 2 ist im wesentlichen scheibenförmig mit zwei einander entgegengesetzten, im wesentlichen zueinander parallelen Oberflächen 4, 6 ausgebildet. Vorzugsweise besteht das Substrat 2 aus Silizium, kann jedoch auch aus anderen Materialien, insbesondere Halbleitermaterialien gefertigt werden.

Wie in Fig. 1b dargestellt, wird ausgehend von der Oberfläche 6 in dem Substrat 2 ein Sackloch 8 ausgebildet. Das Sackloch 8 kann beispielsweise durch ein Verfahren gemäß der WO 99/58746 ausgebildet werden. Das Ätzverfahren, welches auch als elektrochemisches Porenätzen bezeichnet wird, ist ferner detailliert in EP 0 296 348 A, EP 0 645 621 A, WO 99/25026, EP 0 553 465 A sowie DE 198 20 756 beschrieben. Auf diese Druckschriften wird hinsichtlich des Ätzverfahrens in vollem Umfang bezug genommen, so daß deren Offenbarungsgehalt als Teil der Gesamtoffenbarung der vorliegenden Anmeldung zu verstehen ist. Das Sackloch erstreckt sich ausgehend von der Oberfläche 6 im wesentlichen normal zu dieser in Richtung der Oberfläche 4. Das Sackloch 8 weist einen Boden 10 auf, welcher im Inneren des Substrats 2 von der Oberfläche 4 beabstandet ist. Zum Boden 10 hin verengt sich das Sackloch 8. Das Sackloch 8 und insbesondere der sich zum Boden 10 hin verengende Bereich weist dabei im wesentlichen die Form einer zu erzeugenden Pipettenspitze auf. Durch die Formgebung des Sackloches 8 kann somit die Form der zu erzeugenden Pipettenspitze festgelegt werden. Das elektrochemische Porenätzverfahren gestattet es, Poren bzw. Sacklöcher mit extrem großen Aspektverhältnis (Verhältnis Sacklochdurchmesser zu -tiefe) zu ätzen. Beispielsweise sind Aspektverhältnisse von 1:100 und mehr in regelmäßigen Anordnungen in Silizium realisierbar. Der Durchmesser der Sacklöcher liegt bevorzugt im Bereich von 0,5 bis 20 µm, insbesondere 1 bis 2 µm, und der Abstand (Pitch) zwischen den longitudinalen Mittelachsen der Sacklöcher beträgt bevorzugt 10 µm bis einige 100 µm. Die Tiefe der Sacklöcher kann im Bereich von etwa 100 bis 5000 µm liegen, welcher typische Halbleiterwaferdicken umfaßt.

Wie in Fig. 1c gezeigt, wird in einem nächsten Schritt das Substrat 2 mit einer veränderten Oberflächenschicht 12 versehen. Im gezeigten Beispiel ist die veränderte Oberflächenschicht 12 sowohl an den Innenwandungen des Sacklochs 8 sowie auch an den Oberflächen 4 und 6 ausgebildet. Wesentlich ist die Ausbildung in dem Sackloch 8, eine Veränderung der Oberflächenschichten an den Oberflächen 4 und 6 ist nicht unbedingt erforderlich, jedoch verfahrenstechnisch vorteilhaft. Im gezeigten Beispiel ist die Oberflächenschicht 12 zweilagig ausgebildet, d.h. sie besteht aus zwei übereinanderliegenden Schichten. Alternativ ist jedoch auch eine einlagige Ausbildung oder eine Ausbildung mit mehr als zwei Lagen denkbar. Im Falle eines Siliziumsubstrats 2 wird die veränderte Oberflächenschicht 12 bevorzugt durch Oxidieren oder Nitrieren ausgebildet, so daß eine Schicht aus SiO₂ oder Si₃N₄ entsteht. Es können jedoch auch andere Schichten durch Modifizieren einer Oberflächenschicht des Substrats 2 oder durch Aufbringen von Beschichtungsmaterialien erzeugt werden. Die Oberflächenschicht 12 besteht aus einem Material, welches die für eine Pipette gewünschten Materialeigenschaften aufweist, vorteilhafterweise ist sie aus einem Material ähnlich dem Glas einer bekannten Patchpipette gebildet. Dadurch, daß die Oberflächenschicht 12 auf der gesamten Oberfläche des Substrats 2, d.h. den Oberflächen 4, 6 sowie den Innenwandungen des Sackloches 8 ausgebildet wird, kann die Beschichtung oder Oberflächenmodifikation sehr einfach vorgenommen werden, da das gesamte Substrat in einer entsprechenden Atmosphäre oxidiert, nitriert oder beschichtet werden kann.

Fig. 1d zeigt den nächsten Verfahrensschritt, in dem die Oberflächenschicht 12 und ein Teil des Substrats 2 an der Oberfläche 4 des Substrats 2 abgetragen werden. Dabei wird das Substrat soweit abgetragen, daß der Boden 10 des Sackloches 8 geöffnet wird. Die sich ausbildende Öffnung 14 bildet später die Öffnung an der Pipettenspitze. Aus diesem Grunde wird das Substrat 2 und die Oberflächenschicht 12 gerade soweit abgetragen, daß sich in dem Boden 10 eine Öffnung 14 mit der gewünschten Größe ausbildet. Vorzugsweise beträgt der Durchmesser der Öffnung 14 1 bis 2 µm. Das Abtragen erfolgt vorzugsweise durch chemisch-mechanisches Polieren (CMP (chemical mechanical polishing)), kann jedoch auch durch ein anderes geeignetes Abtragverfahren erfolgen. Wichtig ist dabei, daß der Abtrag sehr präzise erfolgt, um die gewünschte Größe der Öffnung 14 genau einstellen zu können.

Der nächste Verfahrensschritt ist in Fig. 1e dargestellt. In diesem Verfahrensschritt findet ein selektives Abtragen des Substrats 2 statt. Dies erfolgt vorzugsweise durch Ätzen, wobei ein Ätzmittel verwendet wird, welches nur das Substrat 2, nicht jedoch die verwendete Oberflächenschicht 12 abträgt. Somit wird nur das Substrat 2 insbesondere an der Oberfläche 4 abgetragen, so daß der Teil der Oberflächenschicht 12 in der Nähe des Bodens 10 des ursprünglichen Sackloches 8 einen Rand 16 bildet. Dieser Rand 16 aus der Oberflächenschicht 12 steht gegenüber der Oberfläche 4 von dem Substrat 2 vor und bildet eine Pipettenspitze. In dieser Pipettenspitze bzw. diesem Rand 16 ist die Öffnung 14 als Pipettenöffnung ausgebildet. Dadurch, daß die Oberflächenschicht 12 auf der Oberfläche 6 des Substrats 2 ausgebildet ist, wird die Oberfläche 6 bei dem selektiven Abtragen nicht abgetragen. Durch Stärke und Dauer des Abtragprozesses, d.h. vorzugsweise des Ätzprozesses kann beeinflußt werden, wieviel des Substrats 2 abgetragen wird. Dadurch kann die Höhe, um die der Rand bzw. die Pipettenspitze 16 von der Oberfläche 4 vorsteht, genau eingestellt werden. Der Abtrag des Substrats 2 an der Oberfläche 4 erfolgt dabei zumindest in der Umgebung des Sackloches bzw. Loches 8, um einen hervorstehenden Rand 16, welcher eine Pipettenspitze definiert, zu bilden.

In einem letzten wesentlichen Verfahrensschritt können, wie in Fig. 1f gezeigt, die Kanten an einem distalen Ende 18 des Randes 16 abgerundet werden, um die endgültige Geometrie der Pipettenspitze 16 zu erzeugen. Dieses Runden der Kanten entlang der Öffnung 14 kann durch eine weiteren kurzen Nach Abschluß dieses Verfahrens entsteht auf der Oberfläche 4 des Substrats 2 eine Pipettenspitze 16, welche derart ausgebildet sein kann, daß sie im wesentlichen einer herkömmlichen Patchpipette entspricht bzw. einen Druckkanal zum reproduzierbaren Dispensieren kleinster Flüssigkeitsmengen auf eine Oberfläche darstellt. Im Unterschied zu bekannten Vorrichtungen hat die bevorzugte erfindungsgemäße Anordnung jedoch den Vorteil, daß die Pipettenspitze 16 in dem Substrat 2 festgehalten und fixiert ist. Auf die beschriebene Art und Weise läßt sich sehr leicht in dem Substrat 2 eine große Anzahl von Pipettenspitzen 16 gleichzeitig ausbilden. Diese Pipettenspitzen 16 werden vorzugsweise in einem vorbestimmten Raster bzw. einer Matrix angeordnet.

Bei einem Einsatz der Vorrichtung für ein Patch-Clamping können zu bearbeitende bzw. zu patchende Vesikel auf das Substrat 2 in dem gleichen Raster abgesetzt werden. Zu diesem Zweck können an dem Substrat 2 weitere Positionierhilfen vorgesehen sein oder es können zusätzliche Positioniereinrichtungen verwendet werden, um die Vesikel auf die Pipettenspitzen 16 abzusetzen.

Bei einem Einsatz der erfindungsgemäßen Vorrichtung als 'Druckkopf' ermöglicht das obige Herstellungsverfahren die Ausbildung von Pipettenarrays (d.h. Drucknadel- bzw. Druckdüsenarrays) mit kleinen Abständen zwischen den Dispensierkanälen. Auf diese Weise lassen sich sowohl eine hohe Anzahl von Spots als auch hohe Spotdichten in einem Druckvorgang gleichzeitig realisieren. Der bevorzugte monolithische Aufbauch des Druckkopfes und die Einbettung der Pipetten bzw. Kapillaren in vorzugsweise Silizium erhöht dessen mechanische Stabilität. Eine nachträgliche Justierung der Pipetten bzw. Druckdüsen zueinander ist nicht notwendig.

Das Loch 8, welches aus dem Sackloch 8 entstanden ist, ist an seiner Innenseite vollständig mit dem Material ausgekleidet, welches die Pipettenspitze 16 bildet. Auf diese Weise kann der gesamte Endbereich einer Patchpipette in dem Substrat 2 zur Verfügung gestellt werden. Durch die Anordnung der Pipette in dem Substrat 2 wird ferner eine Streukapazität im Bereich der Pipettenwand, d.h. in diesem Fall der Oberflächenschicht 12, minimiert.

Im gezeigten Beispiel ist die Oberflächenschicht 12 zweilagig ausgebildet. Dies bewirkt, daß die Pipettenspitze 16 auf ihrer Außenseite ein anderes Material aufweist als an ihrer Innenseite, d.h. im Inneren des Loches 8. Alternativ kann die Oberflächenschicht 12 jedoch auch ein- oder mehrlagig ausgebildet werden. Es ist ferner nicht unbedingt erforderlich die Oberflächenschicht 12 an der gesamten Innenfläche des Loches 8 sowie auf der Oberfläche 6 auszubilden. Beispielsweise könnte nur der Teil des Loches 8 mit der Oberflächenschicht 12 versehen werden, welcher dem Rand 16 zugewandt ist. Die Oberflächenschicht besteht vorzugsweise aus SiO₂, da Siliziumoxid bzw. Siliziumdioxid dem bei herkömmlichen Patchpipetten verwendeten Quarzglas sehr ähnlich ist.

Hier wurden lediglich die Grundzüge des erfindungsgemäßen Verfahrens beschrieben, das Verfahren läßt sich jedoch in vielfältiger Weise abwandeln oder erweitern. Beispielsweise kann anstelle eines Sackloches, wie es in Fig. 1b gezeigt ist, auch gleich ein Durchgangsloch ähnlich zu dem in Fig. 1d gezeigten Loch ausgebildet werden. Ferner kann möglicherweise auf die Oberflächenschicht 12 an der Oberfläche 4 verzichtet werden. In dem-Fall, daß das Loch gleich als Durchgangsloch ausgebildet wird, kann auf den ersten Abtragprozess möglicherweise verzichtet werden und gleich der Schritt des selektiven Ätzens ausgeführt werden. Zusätzlich kann das Verfahren mit einem vorgeschalteten KOH-Ätzprozeß kombiniert werden, der die untere, d.h. dem Rand 16 entgegengesetzte Öffnung des Loches aufweitet, um den Zugangswiderstand der entstehenden Pipetten zu verringern.

In Fig. 2 a) bis f) sind zwei weitere bevorzugte Varianten bezeichnet mit I (linke Spalte) und II (rechte Spalte) eines erfindungsgemäßen Herstellungsverfahrens im Prozeßablauf dargestellt. Bis auf die nachstehend aufgeführten Unterschiede entsprechen die Prozeßschritte von Figs. 2 a) bis f) denjenigen von Figs. 1 a) bis f), wobei gleiche Bezugszeichen gleiche Merkmale der Vorrichtung bezeichnen. Auf eine wiederholte Beschreibung wird somit verzichtet.

Bei der in Fig. 2 dargestellten Variante wird durch geeignete Steuerung des elektrochemischen Porenätzprozesses das Sackloch 8 blasenförmig in dem Substrat 2 ausgebildet. Somit weist das Sackloch 8 ausgehend von der Oberfläche 6 einen zunächst verhältnismäßig kleinen Durchmesser, beispielsweise im Bereich von 0,5 µm bis einige µm, auf. An diesen oberflächennahen Bereich 20 des Sacklochs 8 schließt sich in Normalenrichtung der Oberfläche 6 ein blasenförmiger Bereich 22 an, welcher einen größeren Innendurchmesser aufweist. Beispielsweise kann der Innendurchmesser des blasenförmigen Bereichs 22 einige µm bis 100 µm betragen.

Der Schritt des Abtragens des Substrats 2 ausgehend von der Oberfläche 4 wird derart gesteuert, daß das Substrat 2 lediglich bis zu dem blasenförmigen Bereich 22 des Sacklochs 8 abgetragen wird. Da sich die Innenwände des Sacklochs 8 in einem der Oberfläche 6 des blasenförmigen Bereichs 22 zugewandten Abschnitt aufweiten, ergibt sich eine Pipettenöffnung 14, dessen Öffnungsdurchmesser sich zum distalen Ende des Randes 16 hin vergrößert. Wie in Fig. 2d) dargestellt, lassen sich auf diese Weise Pipettenspitzen 16 mit becherförmiger (Fig. 2 I) oder tricherförmiger Geometrie Die erfindungsgemäßen Vorrichtungen eignen sich ebenfalls für die Zuführung von Synthesestoffen sowie Licht für eine örtlich begrenzte, lichtgesteuerte Synthese von Molekülen. Hinsichtlich der prinzipiellen Funktionsweise der lichtgesteurten Synthese auf planaren Substraten sei auf die EP 0 619 321 und EP 0 476 014 verwiesen. Auf den Offenbarungsgehalt dieser Druckschriften wird hinsichtlich des Aufbaus und des lichtgesteuerten Syntheseverfahren in vollem Umfang bezug genommen, so daß diese Druckschriften insoweit zum Offenbarungsgehalt der vorliegenden Anmeldung gehören. Die Pipetten der erfindungsgemäßen Vorrichtungen können als Lichtwellenleiter zur selektiven, lokalen Beleuchtung eines Substrats genutzt werden. Durch die Wahl von Silizium als einbettendes Material sind die einzelnen Pipetten optisch voneinander isoliert und können getrennt und unabhängig voneinander zum Durchleiten von Licht verwendet werden. Die somit mögliche lokale Beleuchtung gestattet die lichtinduzierte chemische Synthese räumlich begrenzt durchzuführen. Die erfindungsgemäße Möglichkeit, Flüssigkeiten lokal applizieren und am gleichen Ort selektiv beleuchten zu können, eröffnet somit die material- und zeitsparende lokal isolierte, lichtgetriebene chemische Synthese von Molekülen.

Die Versorgung der erfindungsgemäßen Vorrichtung in ihrer Ausgestaltung als 'Druckkopf' mit Flüssigkeit kann beispielsweise über ein Bündel von Glaskapillaren erfolgen. Ein mechanisch robuster Kontakt kann durch Anschmelzen der Kapillaren an dem Druckkopf erreicht werden. Ein Abreißen des Tropfens von dem Rand der Pipette kann insbesondere durch
(a) Anlegen eines Überdrucks am Druckkopf;
(b) Anlegen eines Vakuums im zu bedruckenden Substrat;
(c) die Wirkung der Schwerkraft auf den Flüssigkeitstropfen;
(d) die Ausnutzung des piezoelektrischen Effekts;
(e) eine elektrische Spannungsdifferenz zwischen Tropfen und Substrat (elektrostatische Wechselwirkung);
(f) Anlegen eines elektrischen Stroms (elektrophoretisch oder elektroosmotisch); und/oder
(g) mechanischen Kontakt durch Berührung bei geeigneter Benetzbarkeit des Substrats
ausgelöst werden.

Als bedruckbare Substrate für den erfindungsgemäßen 'Druckkopf' eignen sich poröse Substrate aller Art, insbesondere poröses Silizium, Aluminiumoxid, Silikate und poröse organische Materialien wie Nitrozellulose. Mit sinkender Pipetten- bzw. Porengröße steigen die Kapillarkräfte auf Flüssigkeiten im Kontakt mit einer porösen Oberfläche. Das Dispensieren des Flüssigkeitsvolumens aus dem Druckkopf wird durch die Kapillarwirkung des Substrats erleichtert.

### Bezugszeichenliste

- 2: Substrat
- 4, 6: Oberflächen
- 8: Sackloch, Loch
- 10: Boden
- 12: Oberflächenschicht
- 14: Öffnung
- 16: Rand, Pipettenspitze
- 18: Kante
- 20: oberflächennaher Bereich des Sacklochs 8
- 22: blasenförmiger Bereich des Sacklochs 8

## Patentansprüche

1. Vorrichtung; bei welcher in einem Substrat (2) zumindest eine Pipette in Form eines Durchgangsloches (8) mit einem vorbestimmten Durchmesser ausgebildet ist, wobei ein Rand (16) des Durchgangsloches (8) um ein vorbestimmtes Maß von einer benachbarten Oberfläche (4) des Substrats (2) vorsteht.

2. Vorrichtung nach Anspruch 1, bei welcher zumindest der Rand (16) aus zumindest einem anderen Material als das Substrat (2) besteht und vorzugsweise SiO₂ oder Si₃N₄ umfaßt.

3. Vorrichtung nach Anspruch 1 oder 2, bei welcher eine Innenwandung des Durchgangsloches (8) zumindest teilweise aus einem anderen Material als das Substrat (2) besteht und vorzugsweise SiO₂ oder Si₃N₄ umfaßt.

4. Vorrichtung nach einem der vorangehenden Ansprüche, bei welcher die Innenseite des Randes (16) und vorzugsweise die Innenwandung des Durchgangsloches (8) aus einem anderen Material als die Außenseite des Randes (16) besteht.

5. Vorrichtung nach einem der vorangehenden Ansprüche bei welcher an dem Rand und/oder an der Innenwandung des Durchgangsloches zumindest eine Schicht aus einem elektrisch leitfähigen Material ausgebildet ist.

6. Vorrichtung nach einem der vorangehenden Ansprüche, bei welcher ein distales Ende (18) des Randes (16) gerundet ausgebildet ist.

7. Vorrichtung nach einem der vorangehenden Ansprüche, bei welcher sich das Durchgangsloch (8) zu einem distalen Ende (18) des Randes (16) hin verengt oder aufweitet.

8. Vorrichtung nach einem der vorangehenden Ansprüche, bei welcher das Substrat (2) aus Silizium besteht.

9. Vorrichtung nach einem der vorangehenden Ansprüche, bei welcher in dem Substrat (2) mehrere Pipetten ausgebildet sind, welche vorzugsweise rasterartig in dem Substrat (2) angeordnet sind.

10. Verfahren zum Ausbilden zumindest einer Pipette in einem Substrat (2) mit folgenden Schritten:
Ausbilden zumindest eines Loches (8),
Ausbilden zumindest einer veränderten Oberflächenschicht (12) auf zumindest den Innenflächen des Loches (8),
selektives Abtragen des Substrates (2), wobei die veränderte Oberflächenschicht (12) im wesentlichen nicht angegriffen wird, so daß diese über eine Oberfläche (4) des Substrats vorsteht und einen vorstehenden Rand (16) bildet,
wobei das Loch (8) in einem geeigneten Verfahrensschritt als Durchgangsloch ausgebildet wird.

11. Verfahren nach Anspruch 10, bei welchem das Loch (8) zu der Seite hin, an welcher der Rand (16) ausgebildet wird, sich verjüngend ausgebildet wird.

12. Verfahren nach Anspruch 10 oder 11, bei welchem das Loch (8) zunächst als Sackloch ausgebildet wird.

13. Verfahren nach Anspruch 12, bei welchem nach Ausbilden des Sackloches (8) die einer Öffnung des Sackloches (8) entgegengesetzten Seite (4) des Substrats (2) bis zum Boden (10) des Sackloches (8) abgetragen wird, so daß das Sackloch (8) geöffnet wird, um ein Durchgangsloch (8) zu bilden.

14. Verfahren nach Anspruch 12 oder 13, bei welchem das Sackloch (8) zu seinem Boden (10) hin verjüngend ausgebildet wird.

15. Verfahren nach einem der Ansprüche 12 bis 14, bei welchem das Sackloch (8) durch Ätzen ausgebildet wird.

16. Verfahren nach einem der Ansprüche 13 bis 15, bei welchem das Abtragen der der Öffnung des Sacklochs (8) entgegengesetzten Seite (4) des Substrats (2) durch chemisches und/oder mechanisches Abtragen erfolgt.

17. Verfahren nach einem der Ansprüche 10 bis 16, bei welchem nach dem selektiven Abtragen die Kanten (18) des vorstehenden Randes (16) gerundet werden.

18. Verfahren nach einem der Ansprüche 10 bis 17, bei welchem die veränderte Oberflächenschicht (12) zusätzlich auf einer Oberfläche (4; 6) des Substrats (2) ausgebildet wird.

19. Verfahren nach einem der Ansprüche 10 bis 18, bei welchem die veränderte Oberflächenschicht (12) auf der gesamten Oberfläche (4, 6) des Substrats (2) ausgebildet wird und auf Seite (4) des Substrats (2), an welcher der Rand (16) ausgebildet wird, vor dem selektiven Abtragen vorzugsweise chemisch und/oder mechanisch abgetragen wird.

20. Verfahren nach einem der Ansprüche 10 bis 19, bei welchem das selektive Abtragen des Substrats (2) durch Ätzen erfolgt,
wobei ein Ätzmittel verwendet wird, welches die veränderte Oberflächenschicht (12) im wesentlichen nicht angreift.

21. Verfahren nach einem der Ansprüche 10 bis 20, bei welchem das Substrat (2) aus einem Material besteht, welches ein Halbleitermaterial und insbesondere Silizium umfaßt.

22. Verfahren nach einem der Ansprüche 10 bis 21, bei welchem zumindest die veränderte Oberflächenschicht (12) durch Beschichten und/oder Modifizieren der Oberfläche des Substrats (2), insbesondere Oxidieren oder Nitrieren

23. Verfahren nach einem der Ansprüche 10 bis 22, bei welchem die veränderte Oberflächenschicht (12) zumindest im Bereich des Loches (8) zumindest abschnittweise mehrere Schichten aus vorzugsweise verschiedenen Materialien aufweist.

## Claims

1. Apparatus, in which at least one pipette in the form of a through-hole (8) with a predetermined diameter is formed in a substrate (2), with a rim (16) of the through-hole (8) projecting by a predetermined extent from an adjacent surface (4) of the substrate (2).

2. Apparatus according to Claim 1, in which at least the rim (16) is composed of at least one different material to the substrate (2), and is preferably composed of SiO₂ or Si₃N₄.

3. Apparatus according to Claim 1 or 2, in which an inner wall of the through-hole (8) is composed at least partially of a different material to the substrate (2), and is preferably composed of SiO₂ or Si₃N₄.

4. Apparatus according to one of the preceding claims, in which the inner face of the rim (16) and, preferably, the inner wall of the through-hole (8) are composed of a different material to the outer face of the rim (16).

5. Apparatus according to one of the preceding claims, in which at least one layer composed of an electrically conductive material is formed on the rim and/or on the inner wall of the through-hole.

6. Apparatus according to one of the preceding claims, in which a distal end (18) of the rim (16) is rounded.

7. Apparatus according to one of the preceding claims, in which the through-hole (8) narrows or widens towards a distal end (18) of the rim (16).

8. Apparatus according to one of the preceding claims, in which the substrate (2) is composed of silicon.

9. Apparatus according to one of the preceding claims, in which two or more pipettes are formed in the substrate (2) and are preferably arranged in the form of a grid in the substrate (2).

10. Method for forming at least one pipette in a substrate (2), comprising the following steps:
formation of at least one hole (8),
formation of at least one changed surface layer (12) on at least the inner surfaces of the hole (8),
selective removal of the substrate (2), with the changed surface layer (12) essentially not being attacked, so that this projects above a surface (4) of the substrate and forms a projecting rim (16),
with the hole (8) being formed as a through-hole in a suitable method step.

11. Method according to Claim 10, in which the hole (8) tapers towards the face on which the rim (16) is formed.

12. Method according to Claim 10 or 11, in which the hole (8) is initially in the form of a blind hole.

13. Method according to Claim 12, in which, once the blind hole (8) has been formed, that face (4) of the substrate (2) which is opposite an opening of the blind hole (8) is removed as far as the base (10) of the blind hole (8), so that the blind hole (8) is opened in order to form a through-hole (8).

14. Method according to Claim 12 or 13, in which the blind hole (8) tapers towards its base (10).

15. Method according to one of Claims 12 to 14, in which the blind hole (8) is formed by etching.

16. Method according to one of Claims 13 to 15, in which that face (4) of the substrate (2) which is opposite the opening of the blind hole (8) is removed by chemical and/or mechanical erosion.

17. Method according to one of Claims 10 to 16, in which, after the selective erosion, the edges (18) of the projecting rim (16) are rounded.

18. Method according to one of Claims 10 to 17, in which the changed surface layer (12) is additionally formed on a surface (4; 6) of the substrate (2).

19. Method according to one of Claims 10 to 18, in which the changed surface layer (12) is formed over the entire surface (4, 6) of the substrate (2), and is preferably chemically and/or mechanically removed, before the selective erosion process, on the face (4) of the substrate (2) on which the rim (16) is formed.

20. Method according to one of Claims 10 to 19, in which the selective removal of the substrate (2) is carried out by etching, using an etching agent which essentially does not attack the changed surface layer (12).

21. Method according to one of Claims 10 to 20, in which the substrate (2) is composed of a material which comprises a semiconductor material and, in particular, silicon.

22. Method according to one of Claims 10 to 21, in which at least the changed surface layer (12) is created by coating and/or modification of the surface of the substrate (2), in particular by oxidation or nitriding.

23. Method according to one of Claims 10 to 22, in which the changed surface layer (12) has two or more layers, preferably composed of different materials, at least in places, and at least in the area of the hole (8).

## Revendications

1. Dispositif dans lequel on ménage dans un substrat (2) au moins une pipette sous la forme d'un trou de passage (8) d'un diamètre prédéterminé, un bord (16) du trou de passage (8) faisant saillie dans une mesure prédéterminée d'une surface adjacente (4) du substrat (2).

2. Dispositif selon la revendication 1, dans lequel au moins le bord (16) est constitué d'au moins un autre matériau que le substrat (2) et comprend de préférence du SiO₂ ou du Si₃N₄.

3. Dispositif selon la revendication 1 ou 2, dans lequel une paroi interne du trou de passage (8) est constituée au moins en partie d'un autre matériau que le substrat (2) et comprend de préférence du SiO₂ ou du Si₃N₄ .

4. Dispositif selon l'une quelconque des revendications précédentes, dans lequel la face interne du bord (16) et, de préférence, la paroi interne du trou de passage (8) sont constituées d'un autre matériau que la face externe du bord (16).

5. Dispositif selon l'une quelconque des revendications précédentes, dans lequel au moins une couche d'un matériau conducteur de l'électricité est formée sur le bord et/ou sur la paroi interne du trou de passage.

6. Dispositif selon l'une quelconque des revendications précédentes, dans lequel une extrémité distale (18) du bord (16) a une forme arrondie.

7. Dispositif selon l'une quelconque des revendications précédentes, dans lequel le trou de passage (8) se rétrécit ou s'élargit vers une extrémité distale (18) du bord (16).

8. Dispositif selon l'une quelconque des revendications précédentes, dans lequel le substrat (2) est constitué de silicium.

9. Dispositif selon l'une quelconque des revendications précédentes, dans lequel on ménage dans le substrat (2) plusieurs pipettes qui sont aménagés de préférence en réseau dans le substrat (2).

10. Procédé de formation d'au moins une pipette dans un substrat (2) selon les étapes suivantes :
formation d'au moins un trou (8),
formation d'au moins une couche de surface modifiée (12) sur au moins les faces internes du trou (8), et
enlèvement sélectif de matériau du substrat (2) de sorte que la couche de surface modifiée (12) ne soit sensiblement pas attaquée afin que celle-ci fasse saillie d'une surface (4) du substrat et forme un bord saillant (16),
le trou (8) étant ménagé en trou de passage dans une étape de traitement appropriée.

11. Procédé selon la revendication 10, dans lequel le trou (8) s'amincit vers le côté où est formé le bord (16).

12. Procédé selon la revendication 10 ou 11, dans lequel le trou (8) se présente tout d'abord sous la forme d'un trou borgne.

13. Procédé selon la revendication 12, dans lequel, après formation du trou borgne (8), la face (4) du substrat (2) opposée à une ouverture du trou borgne (8) est soumise à un enlèvement de matériau jusqu'au fond (10) du trou borgne (8) de sorte que le trou borgne (8) soit ouvert pour former un trou de passage (8).

14. Procédé selon la revendication 12 ou 13, dans lequel le trou borgne (8) s'amincit vers son fond (10).

15. Procédé selon l'une quelconque des revendications 12 à 14, dans lequel le trou borgne (8) est formé par gravure.

16. Procédé selon l'une quelconque des revendications 13 à 15, dans lequel l'enlèvement de matériau de la face (4) du substrat (2) opposée à l'ouverture du trou borgne (8) se fait par enlèvement chimique et/ou mécanique.

17. Procédé selon l'une quelconque des revendications 10 à 16, dans lequel, après l'enlèvement sélectif de matériau, les arêtes (18) du bord saillant (16) sont arrondies.

18. Procédé selon l'une quelconque des revendications 10 à 17, dans lequel la couche de surface modifiée (12) est formée en outre sur une surface (4; 6) du substrat (2).

19. Procédé selon l'une quelconque des revendications 10 à 18, dans lequel la couche de surface modifiée (12) est formée sur toute la surface (4, 6) du substrat (2) et est de préférence soumise à un enlèvement de matériau chimique et/ou mécanique avant l'enlèvement sélectif de matériau sur la face (4) du substrat (2) sur laquelle est formé le bord (16).

20. Procédé selon l'une quelconque des revendications 10 à 19, dans lequel l'enlèvement sélectif de matériau du substrat (2) se fait par gravure en utilisant un agent de gravure qui n'attaque sensiblement pas la couche de surface modifiée (12).

21. Procédé selon l'une quelconque des revendications 10 à 20, dans lequel le substrat (2) est constitué d'un matériau qui comprend un matériau semiconducteur et en particulier du silicium.

22. Procédé selon l'une quelconque des revendications 10 à 21, dans lequel au moins la couche de surface modifiée (12) est formée par revêtement et/ou modification de la surface du substrat (2), en particulier par oxydation ou nitruration.

23. Procédé selon l'une quelconque des revendications 10 à 22, dans lequel la couche de surface modifiée (12) présente au moins par segments plusieurs couches de matériaux de préférence différents au moins dans la zone du trou (8).
